# EUROPEAN PATENT APPLICATION

(11) **EP 2 405 484 A1**
(43) Date of publication of application: **11.01.2012**
(21) Application number: 10748542.7
(22) Date of filing: 05.03.2010
(51) Int. Cl.: H01L 31/04

(54) **PROTECTIVE SHEET FOR SOLAR CELL MODULE, AND SOLAR CELL MODULE USING SAME**

(30) Priority: 06.03.2009 JP 2009054203
(71) Applicant: LINTEC Corporation, Tokyo 173-0001 (JP); Mitsubishi Plastics, Inc., Tokyo 103-0021 (JP)
(72) Inventor: TAKANASHI, Yasunari, Tokyo 173-0001 (JP); MATSUSHIMA, Masaru, Tokyo 173-0001 (JP)
(74) Representative: Jansen, Cornelis Marinus
(86) International application number: PCT/JP2010/001547
(87) International publication number: WO 2010/100943

(57) **Abstract**

The invention relates to a solar cell module protective sheet which has two or more gas barrier films, each provided with a deposited layer formed of an inorganic oxide on at least one surface of a base film, in which a material constituting the solar cell module protective sheet is formed of a material transmitting light rays of a wavelength contributing to the generation of electric power, and the solar cell module protective sheet is used as a front sheet, a solar cell module using the solar cell module protective sheet, and the like. According to the invention, it is possible to provide a solar cell module protective sheet having high dampproofness and enabling stable long-term use of a solar cell when the solar cell module protective sheet is used as a front sheet or a back sheet of the solar cell module, and a solar cell module using the solar cell module protective sheet.

## Description

### TECHNICAL FIELD

The present invention relates to a solar cell module protective sheet which is used as a front surface protective sheet or a back surface protective sheet of a solar cell module, and a solar cell module using the solar cell module protective sheet.
Priority is claimed on Japanese Patent Application No. 2009-054203, filed March 6, 2009, the content of which is incorporated herein by reference.

### BACKGROUND ART

In recent years, awareness with regard to environmental problems such as air pollution and global warming has increased, and use of solar cells as a clean energy source has been attracting attention.

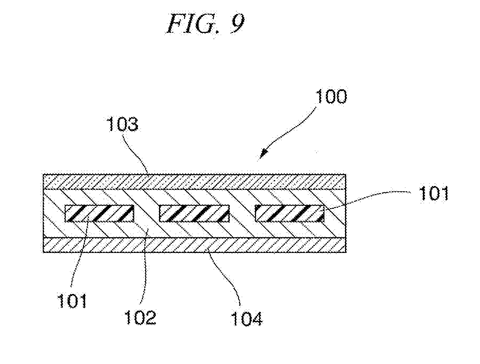

FIG. 9 is a schematic cross-sectional view showing an example of a solar cell module.
This solar cell module 100 is roughly constituted of solar cells 101 formed of crystalline silicon, amorphous silicon or the like, an encapsulant (sealing layer) 102 formed of an electric insulating material which encapsulates the solar cells 101, a front surface protective sheet (front sheet) 103 stacked on a front surface of the encapsulant 102, and a back surface protective sheet (back sheet) 104 stacked on a back surface of the encapsulant 102.
Hereinafter, the front surface protective sheet 103 and the back surface protective sheet 104 will also be collectively referred to as the "protective sheets".

In the solar cell module 100, in order to prevent electric leakage and corrosion of an internal electric circuit, the protective sheets 103 and 104, particularly, the back surface protective sheet 104 is required to have a high water vapor barrier property. Accordingly, the protective sheets 103 and 104 have a structure in which one deposited layer formed of an inorganic oxide such as a silicon oxide or an aluminum oxide is stacked on a base sheet formed of a resin. Due to this laminated structure, the protective sheets 103 and 104 give dampproofness to the solar cell module 100 (for example, see Patent Document 1 or 2).

### CITATION LIST

### PATENT DOCUMENTS

[Patent Document 1]
   Japanese Examined Patent Application Publication No. H4-76231
[Patent Document 2]
   Japanese Unexamined Patent Application Publication No. 2000-294820

### DISCLOSURE OF INVENTION

### PROBLEMS TO BE SOLVED BY THE INVENTION

In some cases, in a solar cell module which is provided with only one deposited layer formed of an inorganic oxide, a pin hole is formed in a solar cell module protective sheet due to contact with a protrusion such as an electrode portion of a solar cell during solar cell manufacturing. Accordingly, when this solar cell module is exposed to solar rays and rain outdoors for a long period of time, or receives a mechanical shock from the outside, moisture gradually invades inside the solar cell module, and thus there is concern that the solar cell deteriorates and cell performance may be adversely affected.

The invention is contrived in view of the above-described problem, and an object thereof is to provide a solar cell module protective sheet which has high dampproofness and enables stable long-term use of a solar cell when used as a front sheet or a back sheet of a solar cell module, and a solar cell module using the solar cell module protective sheet.

### MEANS TO SOLVE THE PROBLEMS

The invention relates to, for example, the following invention.
(1) A solar cell module protective sheet including: two or more stacked gas barrier films, each provided with a deposited layer formed of an inorganic oxide on at least one surface of a base film, in which a material constituting the solar cell module protective sheet is formed of a material transmitting light rays of a wavelength contributing to the generation of electric power, and which is used as a front sheet.
(2) The solar cell module protective sheet according to (1), in which water vapor transmission rate which is measured on the basis of JIS K7129 is less than 10×10⁻¹ g/m²·24 h.
(3) The solar cell module protective sheet according to (1), in which a thermo-adhesive layer is provided on at least one outer surface of the stacked gas barrier films.
(4) The solar cell module protective sheet according to (1), in which a fluorine resin layer is provided on at least one outermost layer.
(5) The solar cell module protective sheet according to (4), in which the fluorine resin layer is a layer which is formed from a coating film obtained by applying a coating material having a fluorine-containing resin.
(6) A solar cell module protective sheet including: two or more stacked gas barrier films, each provided with a deposited layer formed of an inorganic oxide on at least one surface of a base film, which is used as a back sheet.
(7) The solar cell module protective sheet according to (6), in which water vapor transmission rate which is measured on the basis of JIS K7129 is less than 1.0×10⁻¹ g/m²·24 h.
(8) The solar cell module protective sheet according to (6), in which a thermo-adhesive layer is provided on at least one outer surface of the stacked gas barrier films.
(9) The solar cell module protective sheet according to (6), in which a fluorine resin layer is provided on at least one outermost layer.
(10) The solar cell module protective sheet according to (9), in which the fluorine resin layer is a layer which is formed from a coating film obtained by applying a coating material having a fluorine-containing resin.
(11) The solar cell module protective sheet according to (6), in which at least one of the layers constituting the solar cell module protective sheet is formed of a layer reflecting light rays of a wavelength contributing to the generation of electric power.
(12) A solar cell module including: the solar cell module protective sheet according to any one of (1) to (5) which is used as a front sheet; the solar cell module protective sheet according to any one of (6) to (11) which is used as a back sheet; and a solar cell constituting the solar cell module for which a flexible substrate is used.

### EFFECTS OF THE INVENTION

According to a solar cell module protective sheet of the invention, two or more gas barrier films, each of which is provided with a deposited layer formed of an inorganic oxide on at least one surface of a base film, are stacked. Thus, even when pin holes are formed in the gas barrier films, there is a very low possibility that the pin holes overlap each other. Accordingly, the dampproofness of the solar cell module protective sheet increases, and when this is applied to a solar cell module, stable long-term use of a solar cell module is possible. In addition, since the at least two gas barrier films are stacked in the solar cell module protective sheet of the invention, shock resistance also increases. Accordingly, when the solar cell module protective sheet of the invention is applied to a solar cell module, the inside of the solar cell module is completely blocked from the external air and can be kept in a sealed state, and the internal solar cell and encapsulant can be protected from weather, humidity, dust and sand, mechanical shocks or the like.

### BRIEF DESCRIPTION OF THE DRAWINGS

[FIG. 1] FIG. 1 is a schematic cross-sectional view showing a first embodiment of a solar cell module protective sheet of the invention and a solar cell module protective sheet of Example 1.
[FIG. 2] FIG. 2 is a schematic cross-sectional view showing a second embodiment of the solar cell module protective sheet of the invention and a solar cell module protective sheet of Example 3.
[FIG. 3] FIG. 3 is a schematic cross-sectional view showing a third embodiment of the solar cell module protective sheet of the invention and a solar cell module protective sheet of Example 4.
[FIG. 4] FIG. 4 is a schematic cross-sectional view showing a solar cell module protective sheet of Example 2.
[FIG. 5] FIG. 5 is a schematic cross-sectional view showing a solar cell module protective sheet of Example 5.
[FIG. 6] FIG. 6 is a schematic cross-sectional view showing a solar cell module protective sheet of Example 6.
[FIG. 7] FIG. 7 is a schematic cross-sectional view showing a solar cell module protective sheet of Example 7.
[FIG. 8] FIG. 8 is a schematic cross-sectional view showing a solar cell module protective sheet of Comparative Example 1.
[FIG. 9] FIG. 9 is a schematic cross-sectional view showing an example of a solar cell module.

### EMBODIMENTS FOR CARRYING OUT THE INVENTION

Embodiments of a solar cell module protective sheet and a solar cell module using the solar cell module protective sheet of the invention will be described.
In addition, this embodiment is used to specifically describe the purpose of the invention for a better understanding, and the invention is not limited thereto except as otherwise particularly noted.

### (1) First Embodiment

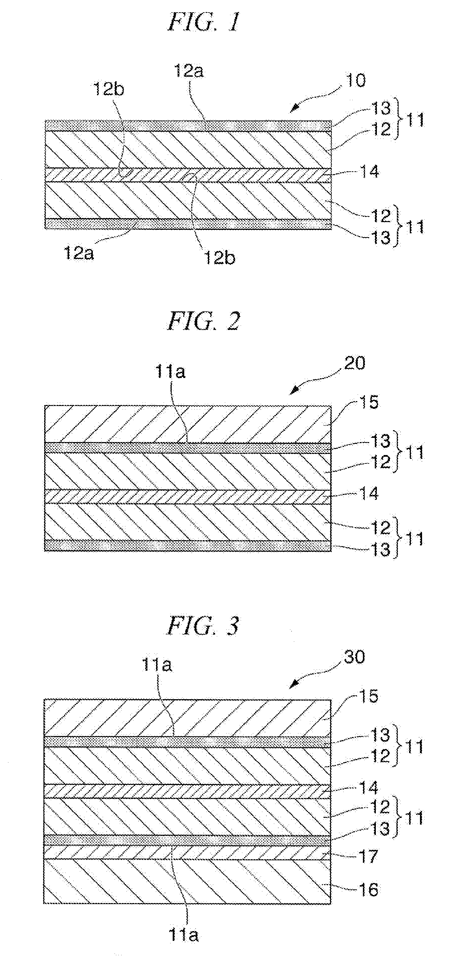

FIG. 1 is a schematic cross-sectional view showing a first embodiment of a solar cell module protective sheet of the invention.
This protective sheet 10 for a solar cell module is applied to the front sheet 103 or the back sheet 104 of the above-described solar cell module 100 (see FIG. 9).
In this embodiment, an example will be described in which the solar cell module protective sheet is applied to the back sheet of a solar cell module.
Hereinafter, the solar cell module protective sheet 10 is also referred to as the back sheet 10.

The back sheet 10 has a laminated structure in which two gas barrier films 11 are stacked, respectively, with an adhesion layer 14 interposed therebetween.
The gas barrier film 11 is constituted of a base film 12 and a deposited layer 13 provided on one surface 12a of the base film 12. The two gas barrier films 11 are stacked so that the surfaces (hereinafter, also referred to as "the other surface of the base film 12") 12b with no deposited layer 13 of the base films 12 face each other.

The base film 12 is not particularly limited if it has an electrical insulating property and the deposited layer 13 can be deposited. However, for example, a resin film or the like is used.

As a resin film which is used as the base film 12, a material which is generally used as a resin film of a back sheet for a solar cell module is selected. As such a resin film, for example, a resin film or sheet formed of a resin such as an olefin-based resin such as polyethylene or polypropylene, an ester-based resin such as polyethylene terephthalate (PET) or polyethylene naphthalate, an amide-based resin such as Nylon (trade name), a carbonate-based resin, a styrene-based resin, a vinyl alcohol-based resin such as polyvinyl alcohol or an ethylene-vinyl acetate copolymer, an acrylonitrile-based resin, a vinyl chloride-based resin, a vinyl acetal-based resin, a vinyl butyral-based resin, or a fluorine-based resin. Among these resin films, a film formed of polyester is preferably used, and more specifically, a PET film is preferably used.

The thickness of the base film 12 is appropriately set on the basis of the electrical insulating property required for the solar cell module. For example, when the base film 12 is a resin film, the thickness thereof is preferably in the range of 10 µm to 300 µm. More specifically, when the base film 12 is a PET film, the thickness thereof is preferably in the range of 10 µm to 300 µm, more preferably in the range of 10 µm to 250 µm, still more preferably in the range of 10 µm to 200 µm, yet more preferably in the range of 10 µm to 150 µm, and most preferably in the range of 10 µm to 125 µm from the point of view of a lightweight property and an electrical insulating property.

The deposited layer 13 is formed of an inorganic oxide, and is not particularly limited if it is formed by deposition on the base film 12.
As a deposition method for formation of the deposited layer 13, for example, a chemical vapor deposition method such as a plasma-enhanced chemical vapor deposition method, a thermal chemical vapor deposition method, or a photo chemical vapor deposition method, or a physical vapor deposition method such as a vacuum deposition method, a sputtering method, or an ion plating method is used. Among these methods, a vacuum deposition method is preferably used in consideration of handleability and layer thickness controllability.

This deposited layer 13 functions as a dampproof layer having a water vapor barrier property. In addition, the weather resistance of the solar cell module can be increased by applying the deposited layer 13 to the solar cell module.

As the inorganic oxide constituting the deposited layer 13, a metal oxide is preferably used.
As the metal oxide, for example, an oxide of metal such as silicon (Si), aluminum (Al), magnesium (Mg), calcium (Ca), potassium (K), tin (Sn), sodium (Na), boron (B), titanium (Ti), lead (Pb), zirconium (Zr), or yttrium (Y) is used. Among these metal oxides, a silicon dioxide (SiO₂) which is a metal oxide of silicon (Si) and an aluminum oxide (Al₂O₃) which is a metal oxide of aluminum (Al) are preferably used.

The deposited layer 13 may be formed of one kind of metal oxide or a plurality of kinds of metal oxides.
When the deposited layer 13 is formed of a plurality of kinds of metal oxides, the deposited layer 13 may be a deposited layer having a laminated structure in which layers each formed of a metal oxide are sequentially deposited, or a deposited layer in which a plurality of kinds of metal oxides are deposited at the same time.

The thickness of the deposited layer 13 is appropriately set in consideration of the water vapor barrier property and is changed in accordance with the kind of the used metal oxide, deposition density or the like. The thickness of the deposited layer 13 is preferably in the range of 5 nm to 200 nm, and more preferably in the range of 10 nm to 100 nm.

The adhesion layer 14 is constituted of an adhesive having an adhesion property to the base film 12.
As the adhesive constituting the adhesion layer 14, a polyacryl-based adhesive, a polyurethane-based adhesive, an epoxy-based adhesive, a polyester-based adhesive, a polyester-polyurethane-based adhesive or the like is used. These adhesives may be used singly or in combination of two or more kinds. Among these adhesives, a polyester-polyurethane-based adhesive is particularly preferably used from the point of view of the excellent adhesion property to the base film 12.

In addition, in order to improve the adhesion property of the adhesive, the other surface 12b of the base film 12 may be subjected to a blast treatment, or a corona treatment and/or a chemical treatment.
The thickness of the adhesion layer 14 is preferably in the range of 1 µm to 20 µm, and more preferably in the range of 3 µm to 10 µm.

According to the back sheet 10, the deposited layer 13 is stacked on the base film 12 to form the gas barrier film 11 having dampproofness and weather resistance, and the two gas barrier films 11 are stacked, respectively, with the adhesion layer interposed therebetween. Therefore, even when pin holes are formed in each gas barrier films 11, there is a very low possibility that the pin holes overlap each other. Accordingly, the dampproofness of the solar cell module protective sheet increases, and when this is applied to a solar cell module, stable long-term use of a solar cell is possible. In addition, since the two gas barrier films 11 are stacked, respectively, with the adhesion layer interposed therebetween in the back sheet 10, shock resistance also increases. Accordingly, when the back sheet 10 is applied to a solar cell module, the inside of the solar cell module is completely blocked from the external air and can be kept in a sealed state, and the internal solar cell and encapsulant can be protected from weather, humidity, sand and dust, mechanical shocks or the like.

In this embodiment, the solar cell module protective sheet (back sheet) 10 having the two gas barrier films 11 stacked with the adhesion layer interposed therebetween has been exemplified. However, the solar cell module protective sheet of the invention is not limited thereto. In the solar cell module protective sheet of the invention, the two gas barrier films may be directly stacked and welded by welding means such as ultrasonic welding, not by interposing the adhesion layer 14 therebetween.
In addition, in this embodiment, the solar cell module protective sheet (back sheet) 10 including the gas barrier films 11 in which the deposited layer 13 is provided on one surface 12a of the base film 12 has been exemplified. However, the solar cell module protective sheet of the invention is not limited thereto. In the solar cell module protective sheet of the invention, both of the surfaces (one surface and the other surface) of the base film may be provided with a deposited layer.

### (2) Second Embodiment

FIG. 2 is a schematic cross-sectional view showing a second embodiment of the solar cell module protective sheet of the invention.
In FIG. 2, the same constituent elements as in the solar cell module protective sheet 10 shown in FIG. 1 will be denoted by the same reference signs, and the description thereof will be omitted.
As in the first embodiment, a solar cell module protective sheet 20 of this embodiment can be applied to the back sheet of a solar cell module.
Hereinafter, the solar cell module protective sheet 20 is also referred to as the back sheet 20.

In the back sheet 20, a fluorine resin layer 15 is further provided in addition to the structure of the back sheet 10 of the first embodiment.
In this embodiment, the configurations of a base film 12, a deposited layer 13, and an adhesion layer 14 are the same as those in the first embodiment.

The fluorine resin layer 15 is provided on an outer surface 11a of one of two gas barrier films 11. The fluorine resin layer 15 is provided as a hardened layer.

The thickness of the fluorine resin layer 15 is set in consideration of weather resistance, chemical resistance, weight saving or the like. The thickness is preferably in the range of 5 µm to 50 µm, and more preferably in the range of 10 µm to 30 µm.

The fluorine resin layer 15 is not particularly limited if it is a layer containing fluorine. Examples of this fluorine-containing layer include a sheet having a fluorine-containing resin, a layer formed of a coating film which is obtained by applying a coating material having a fluorine-containing resin, and the like. Among them, a layer formed of a coating film which is obtained by applying a coating material having a fluorine-containing resin is preferably used from the point of view of decreasing the thickness of the fluorine resin layer 15 for weight savings in the back sheet 20.

When the fluorine resin layer 15 is a layer which is formed from a sheet having a fluorine-containing resin, the fluorine resin layer 15 is stacked on the deposited layer 13 with an adhesion layer interposed therebetween. As the material of the adhesion layer, the same material as that of the adhesion layer 14 in the first embodiment can be used, and the thickness of the adhesion layer can be made to be the same as the thickness of the adhesion layer 14.
When the fluorine resin layer 15 is a layer formed from a coating film which is obtained by applying a coating material having a fluorine-containing resin, the fluorine resin layer 15 is usually stacked on the deposited layer 13 by directly applying a coating material containing a fluorine-containing resin to the deposited layer 13, not by interposing the adhesion layer therebetween.

As the sheet having a fluorine-containing resin, for example, a resin containing polyvinyl fluoride (PVF), ethylene chlorotrifluoroethylene (ECTFE) or ethylene tetrafluoroethylene (ETFE) as a main component which is processed into a sheet is exemplified.
Examples of the resin containing PVF as a main component include "Tedlar (trade name, prepared by E.I. du Pont de Nemours and Company)".
Examples of the resin containing ECTFE as a main component include "Halar (trade name, prepared by Solvay Solexis)".
Examples of the resin containing ETFE as a main component include "Fluon (trade name, prepared by ASAHI GLASS CO., LTD.)".

The coating material containing a fluorine-containing resin is not particularly limited if it is a coating material which is dissolved in a solvent or dispersed in water to be applied.

The fluorine-containing resin which is contained in the coating material is not particularly limited if it is a fluorine-containing resin which is dissolved in a solvent (organic solvent or water) of the coating material, is cross-linkable, and does not damage the advantageous effects of the invention.
As the fluorine-containing resin which is contained in the coating material, a curable functional group-containing fluoroolefin resin is preferable. Examples of this fluoroolefin resin include a copolymer formed of tetrafluoroethylene (TFE), isobutylene, vinylidene fluoride (VdF), hydroxybutyl vinyl ether and other monomers and a copolymer formed of TFE, VdF, hydroxybutyl vinyl ether and other monomers.

Specifically, examples of the fluoroolefin resin include polymers containing chlorotrifluoroethylene (CTFE) as a main component such as "LUMIFLON (trade name, prepared by ASAHI GLASS CO., LTD.)", "CEFRAL COAT (trade name, prepared by CENTRAL GLASS CO., LTD.)", and "FLUONATE (trade name, prepared by DIC Corporation)", polymers containing tetrafluoroethylene (TFE) as a main component such as "ZEFFLE (trade name, prepared by DAIKIN INDUSTRIES, LTD.)", polymers having a fluoroalkyl group such as "Zonyl (trade name, prepared by E.I. du Pont de Nemours and Company)" and "Unidyne (trade name, prepared by DAIKIN INDUSTRIES, LTD.)", polymers containing a fluoroalkyl unit as a main component, and the like.
Among these, from the point of view of weather resistance and pigment dispersibility, polymers containing CTFE as a main component and polymers containing TFE as a main component are preferable, and "LUMIFLON" and "ZEFFLE" are most preferable.

"LUMIFLON" is a noncrystalline resin containing CTFE, several kinds of specific alkyl vinyl ether (VE) and hydroxyalkyl vinyl ether as main constituent units. As this "LUMIFLON", a resin containing a hydroxyalkyl vinyl ether monomer unit is preferably used because it has excellent solvent solubility, cross-linking reactivity, adhesion to a base material, pigment dispersibility, hardness, and flexibility.
"ZEFFLE" is a copolymer of TFE and organic solvent-soluble hydrocarbon olefin, and a resin containing hydrocarbon olefin having a high-reactive hydroxyl group is preferably used because it has excellent solvent solubility, cross-linking reactivity, adhesion to a base material, and pigment dispersibility.

Examples of the copolymerizable monomer which forms the fluorine-containing resin which is contained in the coating material include carboxylic acid vinyl esters such as vinyl acetate, vinyl propionate, vinyl butyrate, vinyl isobutyrate, vinyl pivalate, vinyl caproate, vinyl versatate, vinyl laurate, vinyl stearate, vinyl cyclohexylcarboxylate, and vinyl benzoate, alkyl vinyl ethers such as methyl vinyl ether, ethyl vinyl ether, butyl vinyl ether, and cyclohexyl vinyl ether, and fluorine-containing monomers such as CTFE, vinyl fluoride (VF), VdF, and fluorinated vinyl ether.

Furthermore, the fluorine-containing resin which is contained in the coating material may be a resin formed of one or more kinds of monomers, or may be a terpolymer.
Examples of the terpolymer include "Dyneon THV (trade name, prepared by 3M Company)" which is a terpolymer of VdF, TFE, and hexafluoropropylene. Such a terpolymer is preferably used because characteristics of the respective monomers can be given to the resin. For example, "Dyneon THV" is preferably used because a fluorine resin layer can be prepared at a relatively low temperature and can be adhered to elastomer or hydrocarbon-based plastic and excellent flexibility and optical clarity are obtained.

The coating material may contain a cross-linker, a catalyst, a solvent or the like other than the above-described fluorine-containing resin, and if necessary, may contain an inorganic compound such as a pigment or a filler.

The solvent which is contained in the coating material is not particularly limited if it does not damage the advantageous effects of the invention, and for example, a solvent which contains one or more kinds of organic solvents selected from the group consisting of methyl ethyl ketone (MEK), cyclohexanone, acetone, methyl isobutyl ketone (MIBK), toluene, xylene, methanol, isopropanol, ethanol, heptane, ethyl acetate, isopropyl acetate, n-butyl acetate, and n-butyl alcohol is preferable.
Among such solvents, from the point of view of resolvability of components contained in the coating material and low persistence in the coating film (low boiling temperature), a solvent which contains one or two or more kinds of organic solvents selected from xylene, cyclohexanone, and MEK is preferable.

The pigment and the filler which are contained in the coating material are not particularly limited if they do not damage the advantageous effects of the invention, and examples thereof include titanium dioxide, carbon black, a perylene pigment, a dye, a colorant, mica, a polyamide powder, boron nitride, zinc oxide, aluminum oxide, silica, an ultraviolet absorber, a preservative, a drying agent and the like. More specifically, as the pigment and the filler, "Ti-Pure R105 (trade name, prepared by E.I. du Pont de Nemours and Company)" which is a rutile type titanium dioxide treated by silicon oxide, or "CAB-O-SIL TS 720 (trade name, prepared by Cabot Corporation)" which is hydrophobic silica in which the hydroxyl group of the silica surface is modified by a surface treatment of dimethyl silicon is preferably used in order to give durability.

Since the above-described coating film is preferably hardened by a cross-linker in order to improve weather resistance or abrasion resistance.
The cross-linker is not particularly limited if it does not damage the advantageous effects of the invention. Metal chelates, silanes, isocyanates, or melamines are preferable. When assuming outdoor use of the back sheet 20 for 30 years or more, aliphatic isocyanates are preferable as the cross-linker from the point of view of weather resistance.

The composition of the coating material is not particularly limited if it does not damage the advantageous effects of the invention. It is prepared by mixing a fluorine-containing resin, a pigment, a cross-linker, a solvent and a catalyst.
Regarding the composition ratio of this composition, when the entire coating material is assumed to be 100 mass%, the content of the fluorine-containing resin is preferably in the range of 3 to 80 mass%, and more preferably in the range of 25 to 50 mass%. The content of the pigment is preferably in the range of 5 to 60 mass%, and more preferably in the range of 10 to 30 mass%. The content of the solvent is preferably in the range of 20 to 80 mass%, and more preferably in the range of 25 to 65 mass%.

Examples of the solvent include a mixed solvent of MEK, xylene and cyclohexanone.
In addition, examples of the catalyst include dibutyltin dilaurate, and this catalyst is used in order to promote the cross-link of the fluorine-containing resin and isocyanate.

A known method is used as a method of applying the coating material to the deposited layer 13, and for example, the coating material may be applied by a rod coater so that a desired thickness is formed.
The drying temperature of the coating material applied to the deposited layer 13 may be a temperature which does not damage the advantageous effects of the invention. The drying temperature is preferably in the range of 50 to 130°C from the point of view of reducing the influence on the deposited layer 13 and the base film 12.

According to the back sheet 20, the fluorine resin layer 15 is provided in addition to the back sheet 10 of the first embodiment, and thus weather resistance and chemical resistance can be improved in addition to the advantageous effects of the back sheet 10. Accordingly, in order to improve the weather resistance and the chemical resistance of the back sheet 20, the fluorine resin layer 15 is preferably provided on the outer surface (outer surface 11a of gas barrier film 11) of the deposited layer 13 of the gas barrier film 11.

### (3) Third Embodiment

FIG. 3 is a schematic cross-sectional view showing a third embodiment of the solar cell module protective sheet of the invention.
In FIG. 3, the same constituent elements as those of the solar cell module protective sheet 10 shown in FIG. 1 and the solar cell module protective sheet 20 shown in FIG. 2 will be denoted by the same reference signs, and the description thereof will be omitted.
As in the first and second embodiments, a solar cell module protective sheet 30 of this embodiment can be applied to the back sheet of a solar cell module.
Hereinafter, the solar cell module protective sheet 30 is also referred to as the back sheet 30.

In the back sheet 30, a thermo-adhesive layer 16 is further provided in addition to the structure of the back sheet 20 of the second embodiment.
In this embodiment, the configurations of a base film 12, a deposited layer 13, and an adhesion layer 14 are the same as those in the first embodiment. The configuration of a fluorine resin layer 15 is the same as that in the second embodiment.

Via an adhesion layer 17, the thermo-adhesive layer 16 is provided on an outer surface (outer surface 11a of gas barrier film 11) of the deposited layer 13 of a gas barrier film 11 with no fluorine resin layer 15 provided thereon among two gas barrier films 11.

The thermal adhesion property of the thermo-adhesive layer 16 is a characteristic exhibiting an adhesion property through a heating process. In the invention, the resin constituting the thermo-adhesive layer 16 is not particularly limited if it is a resin having a thermal adhesion property. The temperature of the heating process is preferably in the range of 50 to 200°C.

As the resin constituting the thermo-adhesive layer 16, for example, a resin formed of a polymer containing ethylene vinyl acetate (EVA) or polyolefin as a main component is preferable, and a resin formed of a polymer containing EVA is more preferable.
In general, a sealing resin formed of EVA is frequently used as an encapsulant constituting a solar cell module. When the thermo-adhesive layer 16 is a resin formed of a polymer containing EVA as a main component, the compatibility and adhesion property between the encapsulant and the thermo-adhesive layer 16 can be improved.

The thickness of the thermo-adhesive layer 16 is not particularly limited as long as it does not damage the advantageous effects of the invention. The thickness is appropriately adjusted in accordance with the kind of the thermo-adhesive layer 16. For example, the thickness of the thermo-adhesive layer 16 is preferably in the range of 1 µm to 200 µm. More specifically, when the thermo-adhesive layer 16 is EVA, from the point of a lightweight property and an electrical insulating property, the thickness is preferably in the range of 10 µm to 200 µm, more preferably in the range of 50 µm to 150 µm, and most preferably in the range of 80 µm to 120 µm.

The adhesion layer 17 is constituted of an adhesive having an adhesion property to the thermo-adhesive layer 16 and the deposited layer 13.

The adhesive constituting the adhesion layer 17 is not particularly limited if it does not damage the advantageous effects of the invention. Examples thereof include a polyacryl-based adhesive, a polyurethane-based adhesive, an epoxy-based adhesive, a polyester-based adhesive, a polyester-polyurethane-based adhesive and the like. These adhesives may be used singly or in combination of two or more kinds. Among these adhesives, a polyester-polyurethane-based adhesive is particularly preferably used from the point of view of the excellent adhesion property to the thermo-adhesive layer 16 and the deposited layer 13.

In addition, in order to improve the adhesion property of the adhesive, the outer surface of the deposited layer 13 and the surface of the thermo-adhesive layer 16 which is adhered to the deposited layer 13 may be subjected to a corona treatment and/or a chemical treatment.
The thickness of the adhesion layer 17 is preferably in the range of 1 µm to 20 µm, and more preferably in the range of 3 µm to 10 µm.

According to the back sheet 30, the thermo-adhesive layer 16 is provided in addition to the back sheet 20 of the second embodiment, and thus higher dampproofness than that of the back sheet 20 is obtained. Accordingly, when the back sheet 30 is applied to a solar cell module, stable long-term use of a solar cell is possible. In addition, since the back sheet 30 is provided with the thermo-adhesive layer 16, the back sheet 30 can be easily heat-fused to the encapsulant of a solar cell module.

In this embodiment, the solar cell module protective sheet 30 has been exemplified in which the thermo-adhesive layer 16 is provided on the outer surface of the deposited layer 13 of the gas barrier film 11 with no fluorine resin layer 15 provided thereon. However, the solar cell module protective sheet of the invention is not limited thereto. In the solar cell module protective sheet of the invention, the thermo-adhesive layer may be provided on the outer surface of the fluorine resin layer, or may be provided on the outer surface of the deposited layer of the gas barrier film with no fluorine resin layer provided thereon and the outer surface of the fluorine resin layer.

In addition, in this embodiment, the solar cell module protective sheet 30 has been exemplified in which the thermo-adhesive layer 16 is provided on the outer surface (outer surface 11a of gas barrier film 11) of the deposited layer 13 of the gas barrier film 11 with the adhesion layer 17 interposed therebetween. However, the solar cell module protective sheet of the invention is not limited thereto. In the solar cell module protective sheet of the invention, the thermo-adhesive layer may be a layer which is formed from a coating film obtained by applying a thermo-adhesive resin dissolved in a solvent or dispersed in water to the deposited layer.

Regarding the dampproofness in the first to third embodiments, the water vapor transmission rate which is measured on the basis of JIS K7129 at a temperature of 40°C at a humidity of 90% RH is preferably less than 1.0×10⁻¹ g/m²·24 h.

In the first to third embodiments, the solar cell module protective sheet has been exemplified in which the two gas barrier films 11 are stacked. However, the solar cell module protective sheet of the invention is not limited thereto. In the solar cell module protective sheet of the invention, three or more gas barrier films may be stacked. When three or more gas barrier films are stacked, the solar cell module protective sheet has higher dampproofness and shock resistance. In addition, the number of stacked gas barrier films is not particularly limited, but is preferably equal to or less than 10 from the point of view of the relationship with the thickness of the entire solar cell module protective sheet.

In addition, in the second or third embodiments, the solar cell module protective sheet has been exemplified in which one fluorine resin layer 15 and one thermo-adhesive layer 16 are stacked. However, the solar cell module protective sheet of the invention is not limited thereto. In the solar cell module protective sheet of the invention, a plurality of fluorine resin layers and a plurality of thermo-adhesive layers may be stacked. In this case, the fluorine resin layer and the thermo-adhesive layer are provided between a plurality of gas barrier films or between the gas barrier film and the adhesion layer.

In the first to third embodiments, when the solar cell module protective sheet is applied to the back sheet of a solar cell module, at least one of the layers constituting the solar cell module protective sheet is preferably formed of a layer reflecting the light rays of a wavelength contributing to the generation of electric power. In this manner, since the light rays having transmitted through a solar cell are reflected by a layer reflecting the light rays of a wavelength contributing to the generation of electric power and can be re-used, the power generation efficiency of the solar cell module can be improved.
The layer reflecting the light rays of a wavelength contributing to the generation of electric power can be obtained by mixing a light reflective material in a material of at least one of the layers constituting the solar cell module protective sheet, such as the base film 12, the adhesion layer 14, the fluorine resin layer 15, the thermo-adhesive layer 16, and an outer surface layer 18 to be described later. In addition, it can be obtained by forming a metal deposited layer of aluminum or the like on, for example, the base film 12.
The above-described light reflective material is not particularly limited, but a white pigment is usually used. Examples of the white pigment include titanium dioxide, zinc oxide, aluminum oxide, calcium sulfate, barium sulfate, calcium carbonate and the like. These can be used singly or in combination of two or more kinds.
With respect to the light reflectivity of the surface of the solar cell module protective sheet used as a back sheet, which faces the solar cell, the maximum value of the reflectivity at a wavelength of 400 to 1100 nm is preferably 50% or more.

In addition, in the first to third embodiments, the solar cell module protective sheet has been exemplified which is applied to the back sheet of a solar cell module. However, the solar cell module protective sheet of the invention is not limited thereto. That is, when transparent materials (material transmitting light rays of a wavelength contributing to the generation of electric power) are used as materials constituting the solar cell module protective sheet such as the deposited layer formed of an inorganic oxide and the base film, the solar cell module protective sheet of the invention can also be applied as the front sheet of the solar cell module, and the dampproofness and the shock resistance on the front sheet side can be increased through this application.

Specific examples of the light rays of a wavelength contributing to the generation of electric power include light rays of a wavelength of 400 to 1100 nm. As the light transmission of the solar cell module protective sheet which is used as a front sheet, the minimum value of the light transmission at a wavelength of 400 to 1100 nm is preferably 50% or more, and more preferably 70% or more.

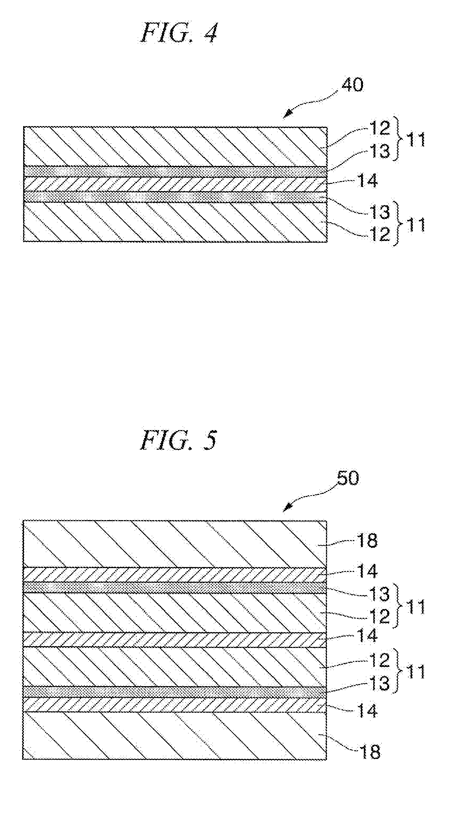

In addition, in the solar cell module protective sheet of the invention, as shown in FIG. 5, an outer surface layer 18 may be provided on both of the surfaces of the solar cell module protective sheet shown in FIG. 1 with the adhesion layer 14 interposed therebetween. The outer surface layer 18 may be provided on any of the surfaces of the solar cell module protective sheet, but is preferably provided as a layer protecting the deposited layer 13.
The same film as the base film 12 can be used as the outer surface layer 18.

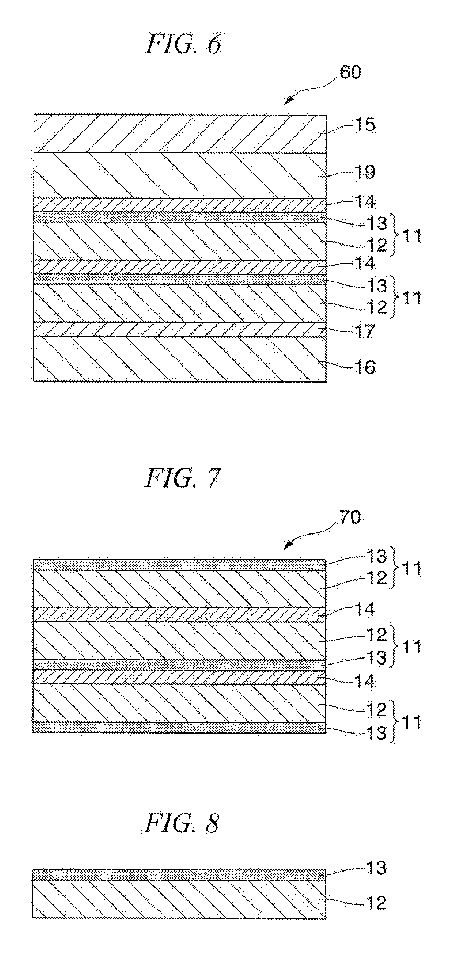

In addition, as shown in FIG. 6, the solar cell module protective sheet of the invention may have a structure in which an intermediate layer 19 is provided on the deposited layer 13 with the adhesion layer 14 interposed therebetween and a coating material containing a fluorine-containing resin is directly applied to the intermediate layer 19 to stack the fluorine resin layer 15 on the intermediate layer 19.
The same film as the base film 12 can be used as the intermediate layer 19.

### (4) Fourth Embodiment

A fourth embodiment of the invention is a solar cell module in which the solar cell module protective sheet selected from the above-described first to third embodiments is provided as either one of a front sheet and a back sheet. A solar cell module exhibiting the above-described advantageous effects can be obtained by applying the solar cell module protective sheet of the first to third embodiments to either one of a front sheet and a back sheet of the solar cell module.

### (5) Fifth Embodiment

A fifth embodiment of the invention is a solar cell module in which the solar cell module protective sheet selected from the above-described first to third embodiments is provided as both of a front sheet and a back sheet. A solar cell module having high dampproofness and shock resistance can be obtained by applying the solar cell module protective sheet of the first to third embodiments to both of a front sheet and a back sheet of the solar cell module. Furthermore, by using a flexible substrate for a solar cell constituting a solar cell module and by providing the solar cell module protective sheet of the above-described first to third embodiments as both of a front sheet and a back sheet, a solar cell module having flexibility can be obtained. In this manner, when solar cell modules are made flexible, mass production thereof can be realized by a roll-to-roll system. In addition, since a solar cell module having flexibility can also be fitted in an object having an arch or parabolic wall surface, it can be installed in a dome building, a sound barrier of an expressway, or the like.

Hereinafter, the invention will be described in detail using the examples and the comparative examples. However, the invention is not limited to the following examples.

### EXAMPLES

### [Preparation of Gas Barrier Film 11]

A PET film having a thickness of 12 µm was used as a base film 12, and a 50 nm-thick film of silicon dioxide (SiO₂) which is a metal oxide was formed on one surface of this PET film by a sputtering method to form a deposited layer 13 formed of the silicon dioxide.
The deposition of the silicon dioxide was performed under the following conditions.
Plasma Generation Gas: Argon, Oxygen
Target Material: Silicon
Gas Flow Rate: Argon 100 scm, Oxygen 50 scm
Electricity Value: DC 2500 W
Pressure in Chamber: 0.2 Pa

### [Preparation of Adhesive Coating Liquid to be Used for Adhesion Layers 14 and 17]

90 parts by mass of a base compound (prepared by MITSUI CHEMICALS POLYURETHANES,INC., trade name "Takelac A-515") of a two-pack polyester-polyurethane-based adhesive and 10 parts by mass of a curing agent (prepared by MITSUI CHEMICALS POLYURETHANES,INC., trade name "Takenate A-3") were mixed to prepare an adhesive coating liquid to be used for adhesion layers 14 and 17.

### [Preparation of Fluorine Resin Coating Liquid to be Used for Fluorine Resin Layer 15]

100 parts by mass of a fluorine resin solution (prepared by ASAHI GLASS CO., LTD., trade name "LUMIFLON LF-200", solid content: 60 mass%), 10 parts by mass of a isocyanate-based curing agent (prepared by Sumika Bayer Urethane Co., Ltd., trade name "SUMIDUR 3300", solid content: 100 mass%), and 30 parts by mass of titanium dioxide fine particles (prepared by E.I. du Pont de Nemours and Company, trade name "Ti-Pure R105") were mixed to prepare a fluorine resin coating liquid to be used for a fluorine resin layer 15.

### [Preparation of Thermo-Adhesive Layer 16]

A thermo-adhesive layer 16 was formed by adjusting the thickness of EVA to 100 µm.

### Example 1

First, two gas barrier films 11 prepared as described above were provided, and an adhesive coating liquid was applied using a Mayer bar to form a thickness after drying of 5 µm on a surface of a base film 12 of one gas barrier film 11. The liquid was dried for one minute at 80°C, and thus an adhesion layer 14 was formed.
Next, on this adhesion layer 14, a base film 12 of the other gas barrier film 11 was laminated so as to be brought into contact with the adhesion layer 14, whereby a solar cell module protective sheet 10 having the structure shown in FIG. 1 was obtained.

### Example 2

First, two gas barrier films 11 prepared as described above were provided, and an adhesive coating liquid was applied using a Mayer bar to form a thickness after drying of 5 µm on a surface of a deposited layer 13 of one gas barrier film 11. The liquid was dried for one minute at 80°C, and thus an adhesion layer 14 was formed.
Next, on this adhesion layer 14, a deposited layer 13 of the other gas barrier film 11 was laminated so as to be brought into contact with the adhesion layer 14, whereby a solar cell module protective sheet 40 having the structure shown in FIG. 4 was obtained.

### Example 3

On one deposited layer 13 of the solar cell module protective sheet prepared in Example 1 and having the structure shown in FIG. 1, a fluorine resin coating liquid was applied using a Mayer bar to form a thickness after drying of 15 µm. A fluorine resin layer 15 was formed by drying the liquid for one minute at 130°C, and thus a solar cell module protective sheet 20 having the structure shown in FIG. 2 was obtained.

### Example 4

On a deposited layer 13 with no fluorine resin layer 15 provided thereon in the solar cell module protective sheet prepared in Example 3 and having the structure shown in FIG. 2, an adhesive coating liquid was applied using a Mayer bar to form a thickness after drying of 5 µm. The liquid was dried for one minute at 80°C, and thus an adhesion layer 17 was formed.
Next, an EVA film having a thickness of 100 µm was provided as a thermo-adhesive layer 16 and laminated so as to be brought into contact with the adhesion layer 17 formed as described above, whereby a solar cell module protective sheet 30 having the structure shown in FIG. 3 was obtained.

### Example 5

On one deposited layer 13 of the solar cell module protective sheet prepared in Example 1 and having the structure shown in FIG. 1, an adhesive coating liquid was applied using a Mayer bar to form a thickness after drying of 5 µm. The liquid was dried for one minute at 80°C, and thus an adhesion layer 14 was formed.
Next, a PET film having a thickness of 125 µm was provided as an outer surface layer 18 and laminated so as to be brought into contact with the adhesion layer 14 formed on one deposited layer 13.
Next, an adhesive coating liquid was applied using a Mayer bar to form a thickness after drying of 5 µm on the other deposited layer 13. The liquid was dried for one minute at 80°C, and thus an adhesion layer 14 was formed.
Next, a PET film having a thickness of 125 µm was provided as an outer surface layer 18 and laminated so as to be brought into contact with the adhesion layer 14 formed on the other deposited layer 13, whereby a solar cell module protective sheet 50 having the structure shown in FIG. 5 was obtained.
In this example, the outer surface layer 18 is provided so that the solar cell module protective sheet prepared in Example 1 and having the structure shown in FIG. 1 is sandwiched from the upper side and the lower side.

### Example 6

First, two gas barrier films 11 prepared as described above were provided, and an adhesive coating liquid was applied using a Mayer bar to form a thickness after drying of 5 µm on a surface of a deposited layer 13 of one gas barrier film 11. The liquid was dried for one minute at 80°C, and thus an adhesion layer 14 was formed.
Next, on this adhesion layer 14, a base film 12 of the other gas barrier film 11 was laminated so as to be brought into contact with the adhesion layer 14.
Next, an adhesive coating liquid was applied using a Mayer bar to form a thickness after drying of 5 µm on a base film 12 of the above-described one gas barrier film 11. The liquid was dried for one minute at 80°C, and thus an adhesion layer 17 was formed.
Next, an EVA film having a thickness of 100 µm was provided as a thermo-adhesive layer 16 and laminated so that the EVA film having a thickness of 100 µm was brought into contact with the adhesion layer 17 formed as described above.
Next, an adhesive coating liquid was applied using a Mayer bar to form a thickness after drying of 5 µm on a deposited layer 13 of the above-described other gas barrier film 11. The liquid was dried for one minute at 80°C, and thus an adhesion layer 14 was formed.
Next, a PET film having a thickness of 125 µm was provided as an intermediate layer 19 and laminated so that the PET film having a thickness of 125 µm was brought into contact with the adhesion layer 14 formed as described above.
Next, a fluorine resin coating liquid was applied using a Mayer bar to form a thickness after drying of 15 µm on the above-described intermediate layer 19. The liquid was dried for one minute at 130°C, and thus a fluorine resin layer 15 was formed. As a result, a solar cell module protective sheet 60 having the structure shown in FIG. 6 was obtained.

### Example 7

On one deposited layer 13 of the solar cell module protective sheet prepared in Example 1 and having the structure shown in FIG. 1, an adhesive coating liquid was applied using a Mayer bar to form a thickness after drying of 5 µm. The liquid was dried for one minute at 80°C, and thus an adhesion layer 14 was formed.
Next, a third gas barrier film 11 was provided and laminated so that the adhesion layer 14 formed on one deposited layer 13 and a base film 12 of the third gas barrier film 11 were brought into contact with each other, whereby a solar cell module protective sheet 70 having the structure shown in FIG. 7 was obtained.

### Comparative Example

The gas barrier film 11 prepared as described above was used as is, and a solar cell module protective sheet having the structure shown in FIG. 8 was obtained.

### [Evaluation of Water Vapor Transmission]

Water vapor transmission rates of the solar cell module protective sheets of Examples 1 to 7 and Comparative Example were measured on the basis of JIS K7129 to evaluate water vapor permeability thereof.
Specifically, using a water vapor transmission rate measuring device (manufactured by MOCON, Inc.,, device name "AQUATRAN", lower limit value of detection of water vapor transmission rate: 0.0005 g/m²·24 h), the water vapor transmission rate of each of the solar cell module protective sheets was measured under the conditions of a temperature of 40°C and a humidity of 90% RH.
The results are shown in Table 1.

**[Table 1]**

| | Water Vapor Transmission Rate (g/m²·24 h) |
|---|---|
| Example 1 | 9.6×10⁻² |
| Example 2 | 9.8×10⁻² |
| Example 3 | 9.4×10⁻² |
| Example 4 | 9.2×10⁻² |
| Example 5 | 1.2×10⁻² |
| Example 6 | 4.6×10⁻² |
| Example 7 | 7.2×10⁻² |
| Comparative Example | 3.3×10⁻¹ |

From the results of Table 1, the water vapor transmission rates of the solar cell module protective sheets of Examples 1 to 7 in which the two or more gas barrier films 11, each formed of the base film 12 and the deposited layer 13, were stacked were less than 1.0×10⁻¹ g/m²·24 h, and it was confirmed that these have sufficient dampproofness as a solar cell module protective sheet.
On the other hand, the water vapor transmission rate of the solar cell module protective sheet of Comparative Example was 3.3×10⁻¹ g/m²·24 h, and it was confirmed that it has insufficient dampproofness as a solar cell module protective sheet.

### Example 8

First, on one outer surface layer 18 of the solar cell module protective sheet prepared in Example 5 and having the structure shown in FIG. 5, an adhesive coating liquid was applied using a Mayer bar to form a thickness after drying of 5 µm. The liquid was dried for one minute at 80°C, and thus an adhesion layer was formed.
Next, an EVA film having a thickness of 100 µm was provided as a thermo-adhesive layer and laminated so that the EVA film having a thickness of 100 µm was brought into contact with the adhesion layer formed as described above, whereby a front sheet was obtained.
Meanwhile, the solar cell module protective sheet 30 prepared in Example 4 and having the structure shown in FIG. 3, and a flexible substrate for a solar cell (glass fiber-reinforced plastic film with amorphous solar cell attached thereto) were provided. A thermo-adhesive layer 16 of the solar cell module protective sheet 30 overlapped the flexible substrate so as to be brought into contact with the flexible substrate, and the solar cell module protective sheet 30 was used as a back sheet.
Next, the thermo-adhesive layer of the above-described front sheet overlapped the flexible substrate so as to be brought into contact with the flexible substrate, and then all of them were subjected to thermo compression by a heated roll to manufacture a solar cell module having a structure of front sheet/flexible substrate/back sheet.
The solar cell module obtained as described above has flexibility and can also be fitted in an object having a parabolic wall surface.

### INDUSTRIAL APPLICABILITY

According to the invention, it is possible to provide a solar cell module protective sheet having high dampproofness and a solar cell module using the solar cell module protective sheet, and stable long-term use of a solar cell is possible.

### DESCRIPTION OF THE REFERENCE SIGNS

- 10, 20, 30, 40, 50, 60, 70:: SOLAR CELL MODULE PROTECTIVE SHEET
- 11:: GAS BARRIER FILM
- 12:: BASE FILM
- 13:: DEPOSITED LAYER
- 14:: ADHESION LAYER
- 15:: FLUORINE RESIN LAYER
- 16:: THERMO-ADHESIVE LAYER
- 17:: ADHESION LAYER
- 18:: OUTER SURFACE LAYER
- 19:: INTERMEDIATE LAYER

## Claims

1. A solar cell module protective sheet comprising:
two or more stacked gas barrier films, each provided with a deposited layer formed of an inorganic oxide on at least one surface of a base film,
wherein a material constituting the solar cell module protective sheet is formed of a material transmitting light rays of a wavelength contributing to the generation of electric power, and
the solar cell module protective sheet is used as a front sheet.

2. The solar cell module protective sheet according to Claim 1,
wherein water vapor transmission rate which is measured on the basis of JIS K7129 is less than 1.0×10⁻¹ g/m²·24 h.

3. The solar cell module protective sheet according to Claim 1,
wherein a thermo-adhesive layer is provided on at least one outer surface of the stacked gas barrier films.

4. The solar cell module protective sheet according to Claim 1,
wherein a fluorine resin layer is provided on at least one outermost layer.

5. The solar cell module protective sheet according to Claim 4,
wherein the fluorine resin layer is a layer which is formed from a coating film obtained by applying a coating material having a fluorine-containing resin.

6. A solar cell module protective sheet comprising:
two or more stacked gas barrier films, each provided with a deposited layer formed of an inorganic oxide on at least one surface of a base film,
wherein the solar cell module protective sheet is used as a back sheet.

7. The solar cell module protective sheet according to Claim 6,
wherein water vapor transmission rate which is measured on the basis of JIS K7129 is less than 1.0×10⁻¹ g/m²·24 h.

8. The solar cell module protective sheet according to Claim 6,
wherein a thermo-adhesive layer is provided on at least one outer surface of the stacked gas barrier films.

9. The solar cell module protective sheet according to Claim 6,
wherein a fluorine resin layer is provided on at least one outermost layer.

10. The solar cell module protective sheet according to Claim 9,
wherein the fluorine resin layer is a layer which is formed from a coating film obtained by applying a coating material having a fluorine-containing resin.

11. The solar cell module protective sheet according to Claim 6,
wherein at least one of the layers constituting the solar cell module protective sheet is formed of a layer reflecting light rays of a wavelength contributing to the generation of electric power.

12. A solar cell module comprising:
the solar cell module protective sheet according to any one of Claims 1 to 5 which is used as a front sheet;
the solar cell module protective sheet according to any one of Claims 6 to 11 which is used as a back sheet; and
a solar cell constituting the solar cell module for which a flexible substrate is used.
